Europäisches Patentamt

**European Patent Office**

Office européen des brevets

(19)

(11) Numéro de publication: **0 021 095**
**B1**

(12) FASCICULE DE BREVET EUROPEEN

(45) Date de publication du fascicule du brevet: **12.09.84**

(21) Numéro de dépôt: **80102985.1**

(22) Date de dépôt: **29.05.80**

(51) Int. Cl.³: **G 03 F 1/00,** G 03 F 7/16, G 03 F 7/20

(54) **Procédé pour fabriquer des réticules sur plaques chromées directement par un générateur d'images.**

(30) Priorité: **29.06.79 FR 7917304**

(43) Date de publication de la demande:
**07.01.81 Bulletin 81/01**

(45) Mention de la délivrance du brevet:
**12.09.84 Bulletin 84/37**

(84) Etats contractants désignés:
**DE FR GB**

(56) Documents cités:
**DE-A-1 447 976**

**SEMICONDUCTOR PRODUCTS AND SOLID-STATE TECHNOLOGY, vol. 8, septembre 1965, pages 38-39 Washington, U.S.A. "Technology topics photo-resist coatings"**
**IBM TECHNICAL DISCLOSURE BULLETIN, vol. 19, no. 7, décembre 1976, page 2688 New York, U.S.A. H. HIRAOKA: "Surface photopolymerization of methacrylic anhydride and dimetha crylimedes"**

(73) Titulaire: **International Business Machines Corporation**
**Old Orchard Road**
**Armonk, N.Y. 10504 (US)**
(84) **DE GB**

(73) Titulaire: **Compagnie IBM FRANCE**
**5 Place Vendôme**
**F-75000 Paris 1er (FR)**
(84) **FR**

(72) Inventeur: **Descamps, Denis**
**8 Allée des Azalées**
**F-77310 Ponthierry (FR)**
Inventeur: **Guermont, Daniel**
**6 rue du Vercors**
**F-91200 Athis-Mons (FR)**
Inventeur: **Piaczinski, Zbigniew**
**17 Résidence "Les Acacias"**
**F-91540 Mennecy (FR)**
Inventeur: **Sautereau, Jacques**
**5 rue de la Fontaine**
**F-91450 Soisy-s/Seine (FR)**

(74) Mandataire: **Klein, Daniel Jacques Henri et al**
**Compagnie IBM France Département de Propriété Industrielle**
**F-06610 La Gaude (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

Courier Press, Leamington Spa, England.

(56) Documents cités:

PHOTOPOLYMERS: PRINCIPLES, PROCESSES AND MATERIALS REGIONAL TECHNICAL CONFERENCE SPONSORED BY MID-HUDSON SECTION SOCIETY OF PLASTIC ENGINEERS INC., 24-26 octobre 1973, pages 78-84, USA, D.E. O'HORA etal.: "Flash exposure system for thin photoresist films"

IBM TECHNICAL DISCLOSURE BULLETIN, vol. 11, no. 8, janvier 1969, pages 952-953 New York, U.S.A. M.I. CURRENT et al.: "Thin film coating"

SOLID-STATE TECHNOLOGY, vol. 21, 8 août 1978, pages 73-79 Washington, U.S.A. K.G. CLARK: "Photoresist technology and processing techniques for fine dimensional control"

PHOTOGRAPHIC SCIENCE AND ENGINEERING, vol. 17, no. 4, juillet-août 1973, pages 386-389 Washington, U.S.A. M.R. GOLDRICK et al.: "Evaluation of exposure parameters for photoresist materials"

SOLID STATE TECHNOLOGY, vol. 20, no. 8, août 1977, pages 81-85 Washington, U.S.A. G.M. HENRIKSEN: "Automatic photo-composition of reticles"

MICROELECTRONICS, vol. 8, no. 1, septembre 1976, pages 9-15 Londres, G.B. B.A. BISHOP: "The manufacture and use of chrome working masks"

C.A. HARPER: HANDBOOK OF MATERIALS AND PROCESSES FOR ELECTRONICS, McGraw Hill 1970 New York, U.S.A. Chapitre 14 "Photofabrication"

Solid State Technology, mai 1978, page 35

## Description

Domaine Technique

La présente invention concerne un procédé pour fabriquer des réticules sur plaques chromées directement par un générateur d'images sans passer par l'intermédiaire d'une plaque émulsion. Elle concerne plus particulièrement un procédé, mettant en oeuvre une plaque de verre recouverte par une couche de chrome, enduite d'une résine photosensible très mince, et un système d'illumination spécial par lampe flash Xénon facilement adaptable sur les équipements de générateurs d'images existants, permettant d'obtenir des réticules par exposition directe de cette plaque. La présente invention concerne à la fois un procédé direct et un procédé inverse qui permet d'obtenir des réticules à contraste inversé.

Etat de la technique antérieure

Les masques (1X) jouent un rôle essentiel dans la fabrication des circuits intégrés à grande échelle (LSI). Ces masques sont obtenus à partir de réticules (10X: cellule unitaire grossie 10 fois) constitués soit par une plaque photographique à la gélatine (procédé émulsion) soit par une plaque chromée. Les premiers sont très fragiles et vieillissent vite. Les seconds sont plus avantageux: durée de vie plus longue, transitions noir/blanc franches, etc. et sont en conséquence très largement utilisés.

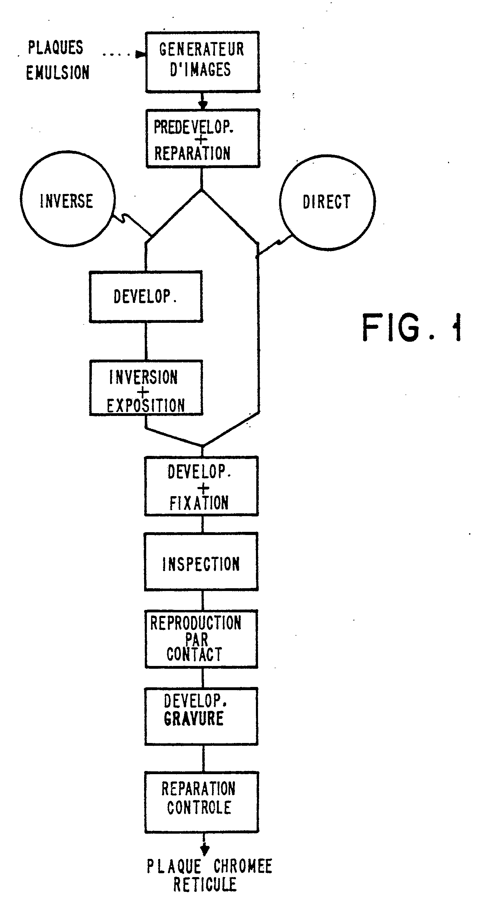

Un procédé classique pour fabriquer les réticules, consiste à utiliser une plaque photographique: (plaque de verre recouverte par une couche d'émulsion) et de l'exposer aux radiations d'une lampe flash Xénon par un générateur d'images. Cette plaque est ensuite développée et fixée par le procédé photographique conventionnel. Cette plaque photographique n'est pas utilisable directement pour la fabrication des masques par photoréduction et répétition, en raison du nombre de défauts inhérents aux plaques photographiques qui seraient reproduits sur toutes les cellules du masque. Il est donc nécessaire de transférer ce dessin sur une plaque de verre chromée sur laquelle il est plus facile de réparer les défauts par les procédés conventionnels de gravure chimique ou par laser. Cette opération de transfert se fait par reproduction par contact à l'exposition d'une lampe à vapeur de mercure. Ce procédé est résumé dans la figure 1.

Les inconvénients du procédé conventionnel sont résumés ci-dessous:

1. Mauvaise qualité des plaques émulsion qui rend indispensable la retouche des défauts sur la copie chrome (opération longue et coûteuse).
2. Distorsion aléatoire du dessin par l'opération de reproduction par contact. Cette distorsion se caractérise par une variation de la dimension hors tout du dessin (grand dimensionnel) de l'ordre de $\pm2\,\mu$ ce qui peut entraîner des pertes en rendement de fabrication semi-conducteurs par désalignement de motifs.
3. Variation aléatoire de la taille des motifs ou des images (petit dimensionnel) liée à l'opération de reproduction par contact. Ces variations de dimension de l'ordre de $\pm1\,\mu$ nécessite des corrections en jouant sur le temps d'exposition lors de la fabrication du masque final.
4. Le procédé est relativement long, 4 heures 30 environ pour le procédé inverse et 4 heures 15 environ pour le procédé direct.

La référence DE—A—1447976 décrit un procédé de fabrication de masques qui est basé sur le dépôt d'une mince couche de chrome sur un substrat transparent en verre à travers une couche de masquage de résine photosensible d'épaisseur inférieure à 5000Å. La couche de résine et le métal qui la recouvre sont ensuite éliminés par la technique dite de décollement (left off).

Dans sa partie relative à l'art antérieur, cette référence signale qu'on peut réaliser un masque par un procédé de type soustractif, c'est-à-dire qu'un substrat transparent recouvert de chrome reçoit une mince couche (2000—5000Å) de résine sensible, qu'est exposée, puis développée selon la configuration désirée et sert enfin de couche de masquage pour le chrome sous-jacent. Cette même référence souligne que ce procédé n'est pas satisfaisant, parce que le chrome est difficile à éliminer sans produire une attaque non désirée de la résine (décollement et/on décapage latéral), il en résulte une mauvaise résolution des lignes.

Il est clair que cet inconvénient croit quant on réduit l'épaisseur de la résine. Cette référence indique en outre les inconvénients produits par les plaques utilisant de l'émulsion.

Exposé de l'invention

Le procédé de l'art antérieur présente donc de nombreux inconvénients, notamment celui de nécessiter d'abord la préparation et le traitement d'une plaque émulsion, puis le transfert de son image sur une plaque chromée.

Un premier objet de l'invention est d'abandonner les plaques "émulsion" et le procédé qui s'y rapporte, pour fournir un nouveau procédé capable de générer directement les réticules "positif" et "négatif" sur des plaques chromées par un générateur d'images, qui assure des avantages éconimiques (gain de temps,...) et techniques (meilleure définition des images):.

Un autre objet de la présente invention est de fournir un procédé de fabrication de réticules qui met en oeuvre une couche très mince résonnante de résine sensible sur une plaque chromée, assurant une précision beaucoup plus grande que celle obtenue avec des couches de résine plus épaisses.

Un autre objet de la présente invention consiste à indiquer les modifications à apporter aux équipements de génération d'images pour leur permettre d'exposer ces couches très minces de résines photosensibles.

Un autre objet de l'invention est d'utiliser un procédé de gravure de type plasma pour améliorer encore la définition des images.

La présente invention concerne donc en premier lieu un procédé de fabrication d'un réticule (10X) à partir d'un substrat constitué par une plaque transparente recouverte par une couche métallique, caractérisé en ce qu'il comporte les étapes suivantes:

A. Dépôt d'une couche ultra-mince d'une résine sensible aux radiations sur ce substrat, dont l'épaisseur est choisie dans le groupe des épaisseurs résonnantes fournies par la relation

$$e = \frac{3\lambda}{4n}(2k+1)$$

où n est l'indice de la résine pour la longueur d'onde ($\lambda$) des radiations choisies, k un entier compris entre 0 et 4, et pré-cuisson de la résine selon les techniques connues.
B. Exposition de la plaque ainsi enduite aux radiations d'un générateur d'images selon la configuration désirée, puis développement de la résine pour éliminer les portions non désirées,
C. Gravure de la couche métallique dans un plasma à travers les ouvertures ainsi produites dans la couche de résinedéveloppée et
D. Elimination de la résine, qui laisse le réticule avec l'image désirée.

Dans une réalisation préférée le substrat est une plaque de verre chromée, la résine utilisée est le photorésist positif AZ 1350J, la source de radiation est constituée par une lampe flash Xénon, de forte intensité, tandis que l'épaisseur choisie est de 1800Å.

La présente invention concerne également un procédé de fabrication d'un réticule à contraste inversé par rapport au précédent, à partir d'un substrat constitué par une plaque transparente recouverte par une couche métallique, caractérisé en ce qu'il comporte les étapes suivantes:

A. Dépôt d'une couche ultra-mince d'une résine sensible aux radiations sur ce substrat, dont l'épaisseur est choisie dans le groupe des épaisseurs résonnantes fournies par la relation

$$e = \frac{3\lambda}{4n}$$

où n est l'indice de la résine pour la longueur d'onde ($\lambda$) des radiations choisies, et précuisson de la résine selon la technique standard,
B. Exposition de la plaque ainsi enduite aux radiations d'un générateur d'images selon la configuration désirée puis développement de la résine et élimination des portions non désirées,
E. Dépôt d'une couche de métal,
F. Elimination du métal recouvrant directement la résine par la technique de décollement,
G. Gravure de la couche métallique initiale à travers les ouvertures pratiquées dans la couche de métal déposie ultérieurement restant, qui laisse le réticule à contraste inversé.

D'autres objets, caractéristiques et avantages de la présente invention ressortiront mieux de l'exposé qui suit, fait en référence aux figures annexées à ce texte, qui représentent un mode de réalisation préféré de celle-ci.

Brève description des figures

La figure 1 représente le diagramme du procédé classique de fabrication des réticules (direct et inverse) à partir d'une plaque recouverte par une émulsion photographique.

La figure 2 représente la courbe de la vitesse de développement d'une résine sensible typique (en Å/sec.) en fonction de l'épaisseur de la résine e (en Å) pour une longueur d'onde de radiation $\lambda$ donnée et pour un certain type de substrat (plaque de verre revêtue de chrome, 45% de réflectivité).

La figure 3 représente le diagramme du procédé de fabrication des réticules (direct et inverse) de la présente invention, à partir de plaques chromées.

Les figures 4 et 5 représentent respectivement les étapes détaillées de la fabrication de réticules à partir de plaques chromées, selon les techniques directe et inverse.

Description de l'invention

La figure 1 représente le procédé classique de l'art antérieur pour obtenir des plaques chromées destinées à être utilisées comme réticules. Le détail du procédé a été donné ci-dessus ainsi que ses inconvénients. Il est donc apparu que la génération directe de réticules étain souhaitable. Diverses approches étaient possibles.

Changer la lampe flash Xénon classique montée sur les équipements de génération d'images par une lampe à arc à vapeur de mercure munie d'un obturateur, en utilisant des plaques de verre chromées enduites de résine photosensible. La lampe à arc à vapeur de mercure est de 500 à 1000 fois plus puissante, elle serait indispensable pour exposer des couches de résine sensibles épaisses, très lentes dans l'exposition comparées aux émulsions photographiques (dans un rapport de 400). Ce procédé qui présenterait l'avantage d'être standard avec le procédé de plaques chromées, serait extrêmement long, donc de faible productivité et son intérêt industriel serait par consequent très réduit.

Une autre solution consisterait à utiliser des plaques chromées enduites d'une couche d'émulsion que l'on trouve dans le commerce. Ce procédé a l'avantage de ne pas nécessiter de modifications au générateur d'images, par contre, ces plaques sont très coûteuses et la qualité des réticules obtenus serait médiocre.

Une autre solution qui est celle retenue, consiste à éliminer complètement le procédé émulsion, tout en gardant la même productivité, en utilisant une couche ultra-mince résonnante de résine sensible et en apportant des modifications mineures aux équipements de génération d'images ainsi qu'au procédé de fabrication de réticules.

Mode de réalisation

La présente invention implique donc des modifications du système d'illumination du générateur d'images (1) pour augmenter son intensité lumineuse, et un nouveau procédé de fabrication (2) basé sur l'utilisation d'une couche ultramince résonnante d'une résine sensible, et une étape par plasma pour fabriquer le réticule.

(1) Le Système d'Illumination:

Un système standard d'illumination des générateurs d'images sur émulsion est composé d'une lampe flash au Xénon d'une puissance de 20 Watts et d'une alimentation électrique délivrant 1 Joule maximum par flash. Cette énergie n'est pas suffisante pour exposer les épaisseurs habituelles (5000—15000Å) des résines classiques telles l'AZ 1350J, fabriquée par Shipley & Co., qui sont beaucoup moins sensibles que les émulsions photographiques (dans un rapport de 400 environ). Le système proposé dans cette invention vise à atteindre l'intensité maximum autorisée à ce jour. Il est composé en premier lieu d'une alimentation électrique perfectionnée délivrant 6,7 Joules maximum par flash à la cadence maximum de 50 flash par seconde. En second lieu il comporte également une lampe flash plus puissante. Cependant, l'énergie maximum par flash est limitée par la puissance moyenne acceptable maximum des lampes flash au Xénon et aussi par la durée du flash (dans le cas d'une exposition à la volée). Les lampes flash Xénon à arc FX 193 (de 100 Watts) ou FX 193 U commercialisées par la Firme EG & G sont recommandées. Ces modifications peuvent être apportées sans difficulté aux générateurs d'images du commerce tel le Mann 3000. Il est également important de travailler sans aucun filtré entre la lampe et la plaque photosensible, la résine jouant son propre rôle de filtre.

D'autres systèmes d'illumination tels que des faisceaux d'électrons ou des faisceaux de rayons X pourraient être également utilisés.

(2) Le Procédé de Fabrication:

La puissance délivrée par le système décrit plus haut ne permet cependant pas d'utiliser les procédés connus aujourd'hui en raison de leur trop faible photosensibilité. Le procédé utilisé pour cette invention ne pouvait être satisfaisant que dans la mesure, où des couches de résine très minces pouvaient être utilisées. Ce point a donc fait l'objet d'études théoriques et on a pu déterminer les épaisseurs auxquelles se produisaient un phénomène d'ondes stationnaires qui permettaient ainsi de tirer le maximum de rendement du faisceau incident de radiation (résonance). L'étude de ce phénomène d'interférences à ondes multiples permet d'obtenir une série de valeurs d'épaisseur de résine auxquelles se produit ce phénomène désiré de résonance.

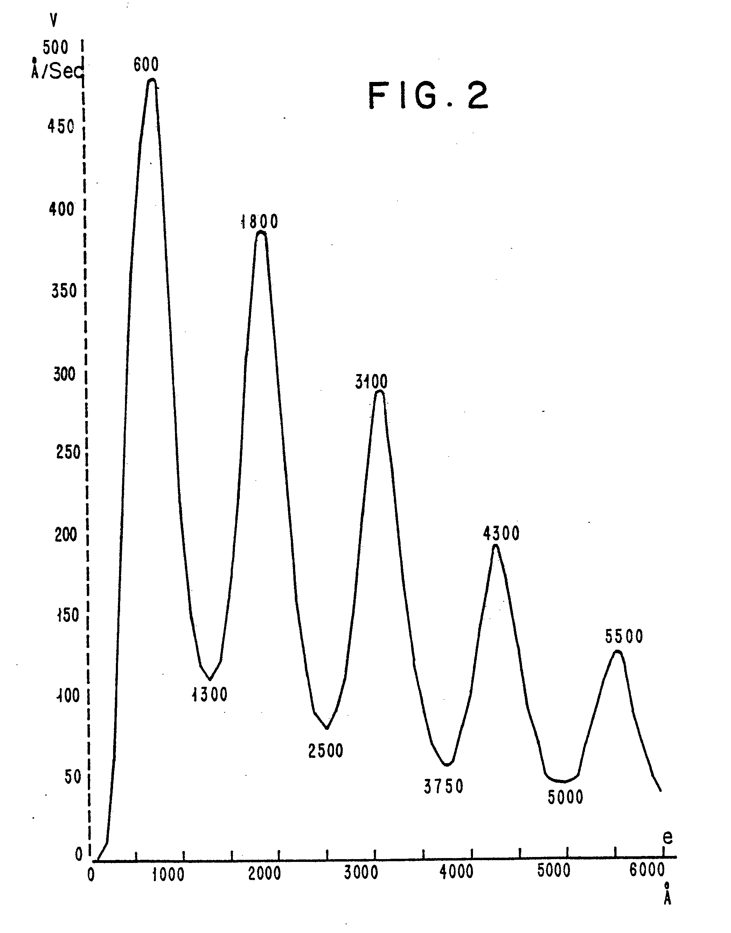

La vitesse de développement est maximum, si l'épaisseur est la plus réduite, si un phénomène d'absorption résonnante se produit, si la réflectivité du substrat (plaque chromée par exemple) est élevée et si la résine utilisée est sensible. Le résultat de ces calculs est montré sur la figure 2, pour la résine classique AZ 1350J. La figure 2 montre la vitesse de développement V en Å/sec. en fonction de l'épaisseur de la résine e en Å, pour une longueur d'onde d'exposition déterminée ($\lambda$=4050 Å) pour les lampes au Xénon). Cette courbe est également valable pour un grand nombre de résines du commerce.

On se rend compte que pour les couches minces de résine, deux épaisseurs sont particulièrement intéressantes e=600 Å et 1800 A. La première était difficile à utiliser dans la mesure où trop mince, elle présentait des lacunes (trous d'épingle après développement), sources de défauts ultérieurs dans le masque. L'épaisseur de 1800 Å apparaît quant à elle optimum comparée aux autres épaisseurs résonnantes 3100 Å, 4300 Å, ..., qui pourraient être utilisées. En raison de la forme arrondie des pics, ces épaisseurs sont approximatives. De façon plus générale d'après un calcul classique d'ondes stationnaires dans les films minces, les épaisseurs choisies doivent obéir à la relation

$$e = \frac{3\lambda}{4n}(2k+1) \quad \begin{array}{l} k=0 \text{ correspond à } 600\text{Å et} \\ k=1 \text{ correspond à } 1800\text{Å} \end{array}$$

dans laquelle $\lambda$ et n sont respectivement la longueur d'onde de la radiation utilisée et n l'indice de la résine pour cette longueur d'onde (pour l'AZ 1350J la valeur approchée de n est 1,63). On peut choisir k entre 0 et 4, mais les valeurs préférées sont bien sûr k=0 et k=1.

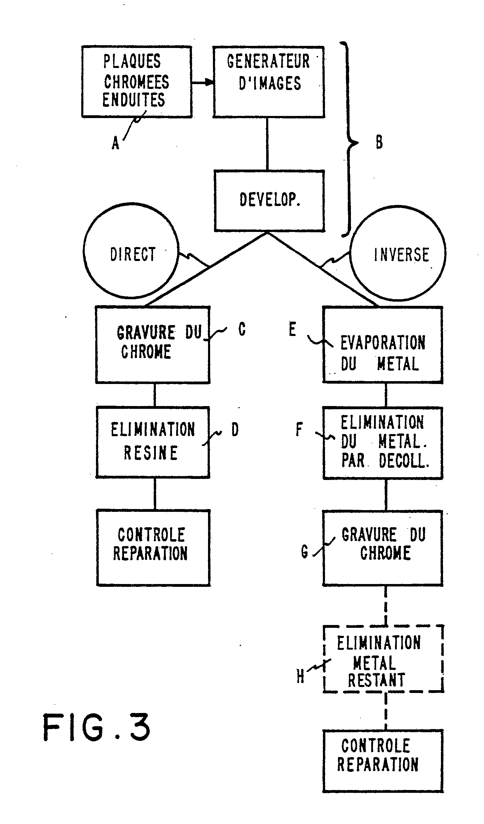

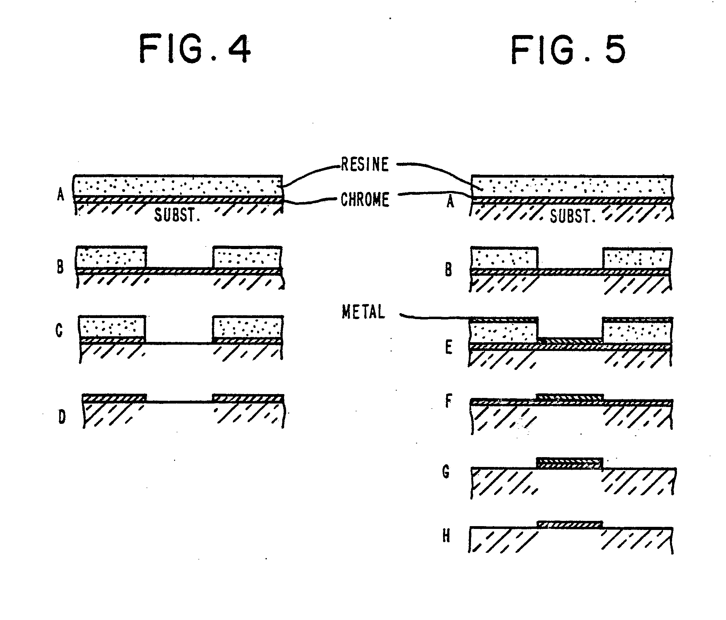

Le procédé sera décrit en détail à l'aide de la figure 3 qui représente le diagramme des différentes étapes du procédé de fabrication (direct et inverse) et des figures 4 et 5 qui *montrent respectivement l'évolution du substrat* dans les procédés direct et inverse, les étapes correspondantes dans ces figures portent des références identiques. L'étape (A) consiste dans l'élaboration des substrats: plaques transparentes recouvertes par une couche opaque. De préférence ces substrats seront constitués par des plaques chromées à haute réflectivité (R=60%) telles que celles fabriquées par Hoya. D'autres corps, tels l'oxyde de fer, l'or, l'aluminium porraient être utilisés à la place du chrome. Les plaques chromées sont enduites d'une couche de résine ultra-mince résonnante, puis introduites dans un générateur d'images classique, par exemple le MANN 3000 modifié comme précisé ci-dessus pour fournir une intensité lumineuse suffisante. La résine photosensible utilisée est l'AZ 1350J de Shipley & Co.. D'autres types de résine pourraient être utilisées. Les couches minces de résine sont obtenues par la dilution de l'AZ 1350J par l'AZ thinner (fabriqué également par Shipley) dans la proportion 25/75 en poids. Avant d'être exposés, les substrats sont précuits de façon classique à 85°C pendant 30 mn. Après exposition (étape B) les substrats sont développés pour éliminer les parties exposées. Le dévelloppeur peut être le développeur AZ fabriqué par Shipley associé à un agent mouillant tel que le FC 126 (0,5%) pour le type de résine mentionné. Le temps de développement est de 1 minute environ. On peut utiliser également un mélange de phosphate trisodique et de métasilicate de sodium. L'épaisseur de résine après le développement est de 1200 Å. Dans le procédé direct (figure 4), c'est-à-dire pour former les réticules de types négatif, les substrats, au cours de l'étape (C), sont soumis à une gravure du chrome à travers les ouvertures de la couche de masquage en résine. Pour obtenir une très grande précision dans la définition du réticule, il est important que ce soit une gravure par plasma (procédé sec), qui soit utilisé, par exemple dans un équipement LFE 501 pendant quatre minutes. En effet, la présence de la couche de résine interdit l'utilisation des procédés humides (attaque chimique) qui produisent une quantité importante de trous dans le chrome. La résine restante est enfin éliminée par un procédé classique, au cours de l'étape (D), par exemple, par pelage (stripping selon la terminologie anglo-saxonne) pendant 10 minutes dans un plasma. Le substrat gravé selon la configuration désirée, constitue après contrôle et réparation éventuellement, le réticule portant l'image désirée. Dans le procédé inverse (figure 5), à l'étape (E), on dépose un métal sur le substrat à inverser, par exemple une couche de 400 Å d'aluminium déposée par évaporation ou par pulvérisation cathodique. D'autres métaux qui conviennent sont l'or, le cuivre et le platine. A l'étape (F), la résine est éliminée par trempage dans un bain ultrasonique de N méthyl pyrolidone, d'acétate d'éthyl, ou dans un mélange d'acides nitrique, chromique et sulfurique; l'aluminium qui recouvre la résine est également éliminé (lift off selon la terminologie anglo-saxonne). Le chrome non protégé est alors éliminé par attaque dans un plasma, ou éventuellement par gravure humide (étape G). On peut de façon facultative (étape H) éliminer la couche d'aluminium par attaque chimique par trempage dans de la soude caustique, ou laisser cette couche qui constitue une protection supplémentaire. Après contrôle et réparation, le réticule est prêt pour être mis en service sur les lignes de fabrication. La mise en oeuvre de ce procédé est simple et permet d'obtenir des images de contraste inversé sans altération de la qualité et du dimensionnel. Le procédé est applicable aux opérations de génération de configurations de circuits intégrés lorsque celles-ci sont effectuées directement sur plaque chromée. Ce procédé est intéressant pour fabriquer des réticules (10X) par écriture directe par un générateur d'images (ou par faisceau électronique) ou même à la limite des masques (1X) par faisceau électronique ou rayons X.

Cette invention présente plusieurs types d'avantages:

avantages économiques: le gain économique est représenté par la suppression complète du procédé émulsion. Le gain porte donc sur la main d'oeuvre, le coût des plaques, les temps de traitement et la surface occupée au sol par les équipements propres à ce procédé,

avantages techniques: cette invention permet de fabriquer des réticules de meilleure qualité par la suppression de plusieurs étapes intermédiaires (procédé émulsion, copie par contact pour obtenir un réticule), ce dernier gain porte sur les paramètres suivants:

définition des images: la suppression de l'opération de contact conduit à améliorer la définition des images c'est-à-dire moins d'arrondissement des angles et bords plus droits,
reproductibilité des tailles d'images et du dimensionnel hors tout du dessin: le gain concernant ces paramètres est également lié à la suppression des opérations intermédiaires: procédé émulsion et copie par contact.
Ces améliorations entraînent donc une réduction de la dispersion des résultats de l'ordre de 1 $\mu$ et de 2 $\mu$ respectivement sur la taille des images (petit dimensionnel) et les dimensions hors tout du dessin (grand dimensionnel),

avantages industriels: cette invention autorise une transformation facile des générateurs d'images existants par remplacement de l'alimentation électrique et de la lampe flash, permettant ainsi la fabrication des réticules pour un coût d'investissement très faible par rapport au coût de la machine elle-même. Enfin les machines modifiées comme décrit plus haut ont une cadence de génération d'images inchangée par rapport au procédé avec émulsion.

Cette cadence d'exposition est de l'ordre de 10 images par seconde et peut dépendre du type de machine considérée.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Procédé de fabrication d'un réticule (10X) à partir d'un substrat constitué par une plaque transparente recouverte par une couche métallique, caractérisé en ce qu'il comporte les étapes suivantes:

A. dépôt d'une couche ultra-mince d'une résine sensible aux radiations sur ce substrat, dont l'épaisseur est choisie dans le groupe des épaisseurs résonnantes fournies par la relation:

$$e = \frac{3\lambda}{4n}(2k+1)$$

où n est l'indice de la résine pour la longueur d'onde ($\lambda$) des radiations choisies, et k un entier compris entre 0 et 4 et précuisson de la résine selon la technique standard,

B. exposition de la plaque aux radiations d'un générateur d'images, selon la configuration désirée puis développement de la résine et élimination des portions non désirées,

C. gravure de la couche métallique dans un plasma à travers les ouvertures ainsi produites dans la couche de résine développée et

D. élimination de la résine qui laisse le réticule avec l'image désirée.

2. Procédé de fabrication d'un réticule à contraste inversé par rapport à celui faisant l'objet de la revendication 1 à partir d'un substrat constitué par une plaque transparente recouverte par une couche métallique, caractérisé en ce qu'il comporte les étapes suivantes:

A. dépôt d'une couche ultra-mince d'une résine sensible aux radiations sur ce substrat, dont l'épaisseur est choisie dans le groupe des épaisseurs résonnantes fournies par la relation:

$$e = \frac{3\lambda}{4n}(2k+1)$$

où n est l'indice de la résine pour le longueur d'onde ($\lambda$) des radiations choisies, et k un entier compris entre 0 et 4 et précuisson de la résine selon la technique standard,

B. exposition de la plaque ainsi enduite aux radiations d'un générateur d'images, selon la configuration désirée puis développement de la résine et élimination des parties non désirées,

E. dépôt d'une couche de métal,

F. élimination du métal recouvrant directement la résine par la technique de décollement,

G. gravure de la couche métallique initiale à travers les ouvertures pratiquées dans la couche de métal déposée ulterieurement restant, qui laisse le réticule à contraste inverse.

3. Procédé de fabrication selon la revendication 2 caractérisé en ce que le métal déposé lors de l'étape E est l'aluminium avec une épaisseur de 400 Å.

4. Procédé de fabrication selon la revendication 2 caractérisé en ce que le métal déposé lors de l'étape E est le platine avec une épaisseur de 100 Å, déposé par pulvérisation cathodique.

5. Procédé de fabrication selon la revendication 4 caractérisé en ce que l'étape F. est remplacée par une étape d'élimination de la résine dans un plasma d'oxygène.

6. Procédé de fabrication selon la revendication 3 ou 4 ou 5 caractérisé en ce qu'il comporte en outre l'étape de H. élimination de la couche de métal restante.

7. Procédé de fabrication selon l'une des revendications ci-dessus, caractérisé en ce que la couche métallique initiale est une couche de chrome à forte réflectivité.

8. Procédé de fabrication selon l'une des revendications ci-dessus caractérisé en ce que la résine utilisée est l'AZ 1350J.

9. Procédé de fabrication selon la revendication 8 caractérisé en ce que la résine utilisée est de l'AZ 1350J diluée avec l'AZ thinner dans la proportion 25/75 en poids.

10. Procédé de fabrication selon la revendication 9 caractérisé en ce que les radiations sont émises par une lampe flash Xénon à arc, à forte intensité (100W, 7J) et que l'épaisseur de la résine est 1800Å.

## Patentansprüche

1. Verfahren zur Herstellung einer Maske (10X) mit einem Substrat, das aus einer durchsichtigen, mit einer Metallschicht ueberzogenen Platte besteht, durch die folgenden Verfahrensschritte gekennzeichnet:

A. Ueberzug des Substrats mit einer ultraduennen Fotolackschicht, deren Dicke aus der Gruppe von den in Resonant befind-lichen, dem folgenden Verhaeltnis ent-sprechenden Dicken ausgewaehlt ist:

$$e = \frac{3\lambda}{4n}(2k+1)$$

worin die Fotolack-Kennzahl fuer die Wellenlaenge ($\lambda$) der ausgewaehlten Strah-lung und k eine ganze Zahl zwischen 0 und 4 ist,
und Vortemperung des Fotolackes nach der konventionellen Technik,

B. Bestrahlung der Platte mit den Strahlungen eines Bilderzeugers dem erwuenschten Muster entsprechend, Entwicklung des Fotolackes und Entfernung der unerwuenschten Teile,

C. Aetzung der Metallschicht in einem Plasma durch die in der entwickelten Fotolackschicht erteugten Oeffnungen, und

D. Entfernung des Fotolackes, so dass die Maske nach dem erwuenschten Bildmuster uebrigbleibt.

2. Verfahren zur Herstellung einer Maske mit einem gegenueber der Maske nach dem Anspruch 1 umgekehrten Kontrast mit einem Substrat, das aus einer durchsichtigen, mit einer Metallschicht ueberzogenen Platte besteht, durch die folgenden Schritte gekennzeichnet,

A. Ueberzug des Substrats mit einer ultraduennen Fotolackschicht, deren Dicke aus der Gruppe von in Resonant befindlichen, dem folgenden Verhaeltnis entsprechenden Dicken ausgewaehlt ist:

$$e = \frac{3\lambda}{4n}(2k+1)$$

worin n die Fotolack-Kennzahl fuer die Wellenlaenge ($\lambda$) der ausgewaehlten Strah-lung und k eine ganze Zahl zwischen 0 und 4 ist,
und Vortemperung des ueberzogenen Fotolackes nach der konventionellen Technik,

B. Bestrahlung der so ueberzogenen Platte mit den Strahlungen eines Bilderzeugers dem erwuenschten Muster entsprechend, Entwicklung des Fotolackes und Entfernung der unerwuenschten Teile,

E. Aufbringen einer Metallschicht,

F. Entfernung der auf dem Fotolack unmittelbar liegenden Metallschicht durch Abheben,

G. Aetzung der urspruenglichen Metallschicht durch die Oeffnungen, die in der uebrigblei-benden, nachfolgend aufgebrachten Metall-schicht hergestellt sind, so dass die Maske mit umgekehrtem Kontrast uebrigbleibt.

3. Verfahren zur Herstellung nach Anspruch 2, dadurch gekennzeichnet, dass der im Schritt E aufgebrachte Metall aus Aluminium besteht und eine Dicke von 400 Å hat.

4. Verfahren zur Herstellung nach Anspruch 2, dadurch gekennzeichnet, dass der im Schritt E aufgebrachte Metall aus durch Kathodenzer-staubung aufgebrachtem Platin besteht, und eine Dicke von 100 Å hat.

5. Verfahren zur Herstellung nach Anspruch 4, dadurch gekennzeichnet, dass der Schritt E durch einen Schritt zur Entfernung des Fotolackes in einem Sauerstoffplasma ersetzt ist.

6. Verfahren zur Herstellung nach Anspruch 3 oder 4 oder 5, dadurch gekennzeichnet, dass es ausserdem den folgenden Schritt aufweist, H. Entfernung der uebrigbleibenden Metallschicht.

7. Verfahren zur Herstellung nach einem der obengenannten Ansprueche, dadurch gekennzeichnet, dass die urspruengliche Metallschicht eine Chromschicht mit hoher Reflektion ist.

8. Verfahren nach einem der oben-gennanten Ansprueche, dadurch gekennzeich-net, dass der verwendete Fotolack dem Fotolack AZ 1350J entspricht.

9. Verfahren nach dem Anspruch 8, dadurch gekennzeichnet, dass der verwendete Fotolack dem in AZ thinner nach dem Gewichtsverhaeltnis 25/75 geloesten Fotolack entspricht.

10. Verfahren zur Herstellung nach Anspruch 9, dadurch gekennzeichnet, dass die Strahlungen von einem Xenon-Blitzbogenlicht mit hoeher Staekre (100 W, 7 J) emittiert sind, und der Fotolack eine Dicke von 1800 Å hat.

## Claims

1. A reticule (10X) manufacturing process in a substrate being comprised of a transparent plate coated with a metal layer, characterized in that it includes the following steps:

A.—Deposit of an ultra-thin photo sensitive resist upon this substrate, being of a thickness which is chosen in the group of the resonant thicknesses according to the relationship:

$$e = \frac{3\lambda}{4n}(2K+1)$$

where n, is the resist index for the wave length ($\lambda$) of the chosen radiations, and k being an integer within 0 and 4, and prebaking of the resist according to the conventional technique,

B.—Exposure of the plate to the radiations of a pattern generator according to the desired configuration, and then development of the resist and removal of the undesired portions,

C.—Plasma-etching of the metal layer through the so-created apertures in the developes resist layer, and

D.—Removal of the resist which gives way to the reticule with the desired pattern.

2. A manufacturing process for manufacturing a reticule having a reversed contrast with respect to the reticule according to claim 1, in a substrate made up with a transparent plate coated with a metal layer, such a process being characterized in that it includes the following steps:

A.—Deposit of an ultra-thin photosensitive resist layer upon this substrate, being of a thickness which is chosen in the group of the resonant thicknesses, according to the relationship:

$$e = \frac{3\lambda}{4n}(2K+1)$$

where n, is the resist index for the wavelength $(\lambda)$ of the chosen radiations, K is an integer within 0 and 4, and prebaking of the resist according to the conventional technique,

B.—Exposure of the so-coated plate to the radiations of a pattern generator according to the desired configuration and then development of the resist, and removal of the undesired portions,

E.—Deposit of a metal layer,

F.—Removal of the metal coating directly the resist by means of the lift-off technique,

G.—Etching the initial metal layer through the apertures made in the remaining further deposited metal layer which gives way to the reversed contrast reticule.

3. A manufacturing process according to claim 2, characterized in that the metal deposited under step G is made of aluminium being 400 Å thick.

4. A manufacturing process according to claim 2, characterized in that the metal deposited under step E is made of platinum being 100 Å thick and cathode-sputter-deposited.

5. A manufacturing process according to claim 4, characterized in that step F is replaced with a step for removing the resist in an oxygen plasma.

6. A manufacturing process according to claim 3, or 4, or 5, characterized in that it further includes the step of H. removing the remaining metal layer.

7. A manufacturing process according to any one of the preceding claims, characterized in that the initial metal layer is a high reflectivity chrome-coated plate.

8. A manufacturing process according to any one of the preceding claims, characterized in that the resist is AZ 1350 J-type resist.

9. A manufacturing process according to claim 8, characterized in that the resist is AZ 130 J-type resist diluted with thinner AZ in proportion 25/75 by weight.

10. A manufacturing process according to claim 9, characterized in that the rays are produced by a high intensity (100 W, 7j) Xenon flash lamp and that the resist is 1800 Å thick.

PLAQUES .... ► GENERATEUR
EMULSION          D'IMAGES

PREDEVELOP.
+
REPARATION

INVERSE                    DIRECT

DEVELOP.

FIG. 1

INVERSION
+
EXPOSITION

DEVELOP.
+
FIXATION

INSPECTION

REPRODUCTION
PAR
CONTACT

DEVELOP.
GRAVURE

REPARATION
CONTROLE

PLAQUE CHROMEE
RETICULE

1

FIG. 2

FIG.3

# FIG. 4

# FIG. 5